# EUROPEAN PATENT APPLICATION

(11) **EP 4 220 705 A1**
(43) Date of publication of application: **02.08.2023**
(21) Application number: 21885093.1
(22) Date of filing: 25.10.2021
(51) Int. Cl.: H01L 23/36

(54) **HEAT DISSIPATION ASSEMBLY REDUCING ELECTROMAGNETIC NOISE OF CHIP, CHIP PACKAGING ASSEMBLY, AND ELECTRONIC DEVICE**

(30) Priority: 26.10.2020 CN 202011161152
(71) Applicant: Huawei Technologies Co., Ltd., Shenzhen, Guangdong 518129 (CN)
(72) Inventor: XIONG, Zhenxing, Shenzhen, Guangdong 518129 (CN); LAN, Zengqi, Shenzhen, Guangdong 518129 (CN); ZHAO, Caijun, Shenzhen, Guangdong 518129 (CN); XU, Shuai, Shenzhen, Guangdong 518129 (CN)
(74) Representative: Grünecker Patent- und Rechtsanwälte PartG mbB
(86) International application number: PCT/CN2021/126125
(87) International publication number: WO 2022/089366

(57) **Abstract**

This application discloses a heat dissipation assembly for reducing electromagnetic noise of a chip, a chip packaging assembly, and an electronic device. The heat dissipation assembly includes a heat sink, a seal ring, and a suppression ring. The suppression ring is connected between the seal ring and the heat sink, and is configured to surround a chip. The heat dissipation assembly is configured to form an enclosed space together with a substrate carrying the chip, so that the chip is located in the enclosed space. The suppression ring is configured to shield an electromagnetic wave radiated by the chip.

## Description

This application claims priority to Chinese Patent Application No. 202011161152.1, filed with the China National Intellectual Property Administration on October 26, 2020 and entitled "HEAT DISSIPATION ASSEMBLY FOR REDUCING ELECTROMAGNETIC NOISE OF CHIP, CHIP PACKAGING ASSEMBLY, AND ELECTRONIC DEVICE", which is incorporated herein by reference in its entirety.

### TECHNICAL FIELD

This application relates to the technical field of chips, and in particular, to a heat dissipation assembly for reducing electromagnetic noise of a chip, a chip packaging assembly, and an electronic device.

### BACKGROUND

As power consumption of a chip sharply increases, bare die packaging gradually becomes a mainstream process of packaging the chip with high power consumption, to improve a heat dissipation benefit of the chip. However, it is found through simulation that a chip in a packaging assembly based on a bare die packaging process has relatively high externally radiated power. Consequently, the chip packaging assembly has relatively high electromagnetic noise.

### SUMMARY

An objective of this application is to provide a heat dissipation assembly for reducing electromagnetic noise of a chip, a chip packaging assembly, and an electronic device, to resolve a problem that an existing chip packaging assembly has relatively high electromagnetic noise.

To resolve the foregoing technical problem, this application provides a heat dissipation assembly for reducing electromagnetic noise of a chip. The heat dissipation assembly includes a heat sink, a seal ring, and a suppression ring. The suppression ring is connected between the seal ring and the heat sink, and is configured to surround a chip. The heat dissipation assembly is configured to form an enclosed space together with a substrate carrying the chip, so that the chip is located in the enclosed space. The suppression ring is configured to shield an electromagnetic wave radiated by the chip. It should be understood that based on a shielding effect of the suppression ring on the electromagnetic wave, in comparison with an existing bare die packaging-based chip packaging assembly, the heat dissipation assembly can ensure that a chip packaging assembly in which the heat dissipation assembly is used has relatively low electromagnetic noise while ensuring a heat dissipation benefit. The corresponding chip packaging assembly still maintains a relatively good electromagnetic noise suppression effect in a high frequency range above 20 GHz, so that radiated power of an electromagnetic wave in the high frequency range is still kept relatively low, to reduce electromagnetic pollution and a possibility of crosstalk between the chip packaging assembly and a radio frequency circuit.

In some embodiments, the suppression ring is located on a side that is of the seal ring and that faces the heat sink. When the heat dissipation assembly is used in the chip packaging assembly, through cooperation between the suppression ring, the heat sink, and the seal ring, the heat dissipation assembly can suppress the electromagnetic wave radiated by the chip to outside of the chip packaging assembly while meeting a heat dissipation requirement of the chip packaging assembly, to reduce electromagnetic noise of the chip packaging assembly.

In some embodiments, the heat sink includes a heat sink body and a ring-shaped support. The ring-shaped support is located on a side of the heat sink body and spaced from the seal ring. The suppression ring is partially or completely sandwiched between the ring-shaped support and the seal ring. When the heat dissipation assembly is used in the chip packaging assembly, through cooperation between the suppression ring, the heat sink, and the seal ring, the heat dissipation assembly can suppress the electromagnetic wave radiated by the chip to outside of the chip packaging assembly while meeting a heat dissipation requirement of the chip packaging assembly, to reduce electromagnetic noise of the chip packaging assembly.

In some embodiments, the suppression ring includes a first ring-shaped part and a second ring-shaped part. The first ring-shaped part is sandwiched between the ring-shaped support and the seal ring. The second ring-shaped part is sandwiched between the heat sink body and the seal ring.

In some embodiments, the suppression ring is connected to the seal ring and the heat sink without a gap. In this way, there is no gap between the seal ring, the suppression ring, and the heat sink, to improve a shielding effect of the heat dissipation assembly on the electromagnetic wave radiated by the chip.

In some embodiments, the suppression ring is a flexible conductive gasket. The conductive gasket is sandwiched between the seal ring and the heat sink through elastic deformation. The suppression ring has specific elasticity. Based on this, while shielding the electromagnetic wave, the suppression ring may further serve as a cushion to protect the chip, to reduce pressure borne by the chip.

In some embodiments, the conductive gasket includes an elastic inner core and a conductive outer layer. The conductive outer layer is wrapped around the elastic inner core. Through the elastic inner core, the conductive gasket may have specific elasticity, to implement good bonding. Through the conductive outer layer, the conductive gasket may be electrically connected to the heat sink and the seal ring, to ensure the effect of shielding the electromagnetic wave radiated by the chip.

In some embodiments, the elastic inner core is made of a foam material, and the conductive outer layer is made of conductive fiber cloth. The foam material may be, for example, a material having specific elasticity, such as polyurethane. The conductive fiber cloth may be, for example, a material having high electrical conductivity, such as nickel/copper (Ni/Cu).

In some embodiments, the conductive gasket is conductive foam. It should be understood that a conductive sponge also has electrical conductivity and compressibility, and can implement good bonding with the seal ring and the heat sink and shield the electromagnetic wave.

This application further provides another heat dissipation assembly for reducing electromagnetic noise of a chip. The heat dissipation assembly includes a heat sink, a seal ring, and a suppression ring. The suppression ring is located between the seal ring and the heat sink, and is configured to surround a chip. The heat dissipation assembly is configured to form an enclosed space together with a substrate carrying the chip, so that the chip is located in the enclosed space. The suppression ring is configured to absorb an electromagnetic wave radiated by the chip. It should be understood that the suppression ring in this embodiment may be connected to at least one of the seal ring and the heat sink. That is, there may be a specific gap between the seal ring, the suppression ring, and the heat sink. Based on an absorption and attenuation effect of the suppression ring on the electromagnetic wave, in comparison with an existing bare die packaging-based chip packaging assembly, it is also difficult for the electromagnetic wave radiated by the chip to penetrate through the gap to outside. Therefore, a chip packaging assembly in which the heat dissipation assembly is used can have relatively low electromagnetic noise. The chip packaging assembly still maintains a relatively good electromagnetic noise suppression effect in a high frequency range above 20 GHz, so that radiated power of an electromagnetic wave in the high frequency range is still kept relatively low, to reduce electromagnetic pollution and a possibility of crosstalk between the chip packaging assembly and a radio frequency circuit.

In some embodiments, the suppression ring is located on a side that is of the seal ring and that faces the heat sink. When the heat dissipation assembly is used in the chip packaging assembly, through cooperation between the suppression ring, the heat sink, and the seal ring, the heat dissipation assembly can suppress the electromagnetic wave radiated by the chip to outside of the chip packaging assembly while meeting a heat dissipation requirement of the chip packaging assembly, to reduce electromagnetic noise of the chip packaging assembly.

In some embodiments, the heat sink includes a heat sink body and a ring-shaped support. The ring-shaped support is located on a side of the heat sink body and spaced from the seal ring. The suppression ring is partially or completely located between the ring-shaped support and the seal ring. When the heat dissipation assembly is used in the chip packaging assembly, through cooperation between the suppression ring, the heat sink, and the seal ring, the heat dissipation assembly can suppress the electromagnetic wave radiated by the chip to outside of the chip packaging assembly while meeting a heat dissipation requirement of the chip packaging assembly, to reduce electromagnetic noise of the chip packaging assembly.

In some embodiments, the suppression ring includes a first ring-shaped part and a second ring-shaped part. The first ring-shaped part is located between the ring-shaped support and the seal ring. The second ring-shaped part is located between the heat sink body and the seal ring.

In some embodiments, the suppression ring is a ring-shaped mechanical part made of a wave-absorbing material. The wave-absorbing material may be, for example, graphite, graphene, carbon fiber, magnetic ceramic, or a conductive polymer.

In some embodiments, the first ring-shaped part is a conductive gasket; or the first ring-shaped part is a ring-shaped mechanical part made of a wave-absorbing material.

In some embodiments, the second ring-shaped part is a conductive gasket; or the first ring-shaped part is a ring-shaped mechanical part made of a wave-absorbing material. When the second ring-shaped part is the conductive gasket, the second ring-shaped part may further reduce pressure borne by the chip.

In some embodiments, the seal ring is an enclosed ring-shaped structure; or the seal ring includes a plurality of substructures, and the plurality of substructures are spaced apart on a periphery of the chip.

This application further provides still another heat dissipation assembly for reducing electromagnetic noise of a chip. The heat dissipation assembly includes a heat sink and a suppression ring. The suppression ring is located on a side of the heat sink, and is configured to surround a chip. The heat dissipation assembly is configured to form an enclosed space together with a substrate carrying the chip, so that the chip is located in the enclosed space. The suppression ring is a conductive gasket, or the suppression ring is a ring-shaped mechanical part made of a wave-absorbing material.

This application further provides a chip packaging assembly. The chip packaging assembly includes a chip, a substrate, and the heat dissipation assembly for reducing electromagnetic noise of a chip in the foregoing embodiments. The chip is disposed on the substrate. The substrate and the heat dissipation assembly jointly form an enclosed space. The chip is located in the enclosed space.

This application further provides an electronic device. The electronic device includes the chip packaging assembly for reducing electromagnetic noise in the foregoing embodiment. The electronic device may be a router or a switch.

In this application, when the heat dissipation assembly is used in the chip packaging assembly, through cooperation between the suppression ring and a related structure, the heat dissipation assembly can suppress the electromagnetic wave radiated by the chip to the outside of the chip packaging assembly while meeting the heat dissipation requirement, to reduce the electromagnetic noise of the chip packaging assembly and the possibility of crosstalk between the chip packaging assembly and the radio frequency circuit.

### BRIEF DESCRIPTION OF DRAWINGS

FIG. 1 is a schematic diagram of an existing chip packaging assembly;
FIG. 2 is a schematic diagram of a chip packaging assembly according to an embodiment of this application;
FIG. 3 is a schematic diagram of a seal ring according to an embodiment of this application;
FIG. 4 is a schematic diagram of a seal ring according to another embodiment of this application;
FIG. 5 is a schematic diagram of a chip packaging assembly according to another embodiment of this application;
FIG. 6 is a top view of a substrate, a seal ring, and a chip according to an embodiment of this application;
FIG. 7 is a diagram of simulation test data of an electromagnetic noise shielding effect of a chip packaging assembly according to an embodiment of this application;
FIG. 8 is a diagram of pressure test data of a chip in an existing chip packaging assembly;
FIG. 9 is a diagram of pressure test data of a chip in a chip packaging assembly according to an embodiment of this application;
FIG. 10 to FIG. 12 are schematic diagrams of a chip packaging assembly according to another embodiment of this application;
FIG. 13 is a schematic diagram of a chip packaging assembly according to still another embodiment of this application;
FIG. 14 is a schematic diagram of a chip packaging assembly according to yet another embodiment of this application; and
FIG. 15 is a schematic diagram of a chip packaging assembly according to still yet another embodiment of this application.

### DESCRIPTION OF EMBODIMENTS

The following clearly and completely describes the technical solutions in embodiments of this application with reference to the accompanying drawings in embodiments of this application.

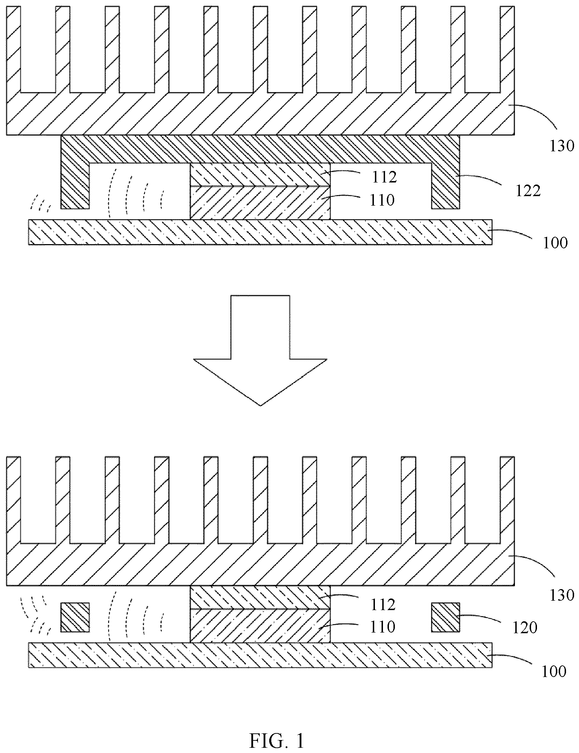

With reference to FIG. 1, as an integration level of a chip increases, the chip has a stronger processing capability. However, power consumption of the chip also sharply increases. It should be understood that a chip with higher power consumption generates more heat during operation, and the heat needs to be dissipated in time. In recent years, to improve a heat dissipation benefit of a chip, a metal lid (Lid) packaging process is gradually replaced by a bare die (Die) packaging process in the industry. The chip is packaged to form a chip packaging assembly through bare die packaging.

It should be understood that in the bare die packaging-based chip packaging assembly, a chip 110 is disposed on a substrate 100, and a seal ring (Seal Ring) 120 surrounds the chip 110. In addition, a metal lid 122 originally covering the chip 110 is removed. Because the metal lid 122 covering the chip 110 is removed, the chip 110 may be connected to a heat sink 130 through a thermal interface material (TIM, Thermal Interface Material) 112, and directly conduct heat to the heat sink 130 to implement heat dissipation. In this way, a heat dissipation benefit of the bare die packaging-based chip packaging assembly is improved, and a heat dissipation requirement of the chip can be met.

However, after the metal lid 122 is removed, there is a relatively large height difference between the substrate 100 and the heat sink 130 in the chip packaging assembly. Although the seal ring 120 surrounds the chip 110, the seal ring 120 cannot provide good shielding between the substrate 100 and the heat sink 130 due to factors such as a component process tolerance, a packaging requirement, and a subsequent test. This results in a gap between the seal ring 120 and the heat sink 130, and/or is prone to a gap between the substrate 100 and the seal ring 120.

Due to the gaps, the chip 110 packaged through bare die packaging is easier to radiate an electromagnetic wave to outside of the chip packaging assembly. The radiated electromagnetic wave is electromagnetic noise. After simulation is performed on the bare die packaging-based chip packaging assembly, it is found that an electromagnetic wave externally radiated by the bare die packaging-based chip packaging assembly has higher radiated power than that externally radiated by a metal lid packaging-based chip packaging assembly. That is, the bare die packaging-based chip packaging assembly has higher electromagnetic noise.

An electromagnetic wave with a higher frequency has a smaller wavelength. An electromagnetic wave in a high frequency range is easier to be radiated to outside through a narrow gap than an electromagnetic wave in a low frequency range. For example, it is found through simulation that in a high frequency range of 20 GHz to 35 GHz, radiated power of electromagnetic noise externally radiated by the bare die packaging-based chip packaging assembly increases by 5 dB to 10 dB in comparison with the metal lid packaging-based chip packaging assembly. Based on this, in the bare die packaging-based chip packaging assembly, it is more difficult to suppress the electromagnetic wave in the high frequency range. The radiated electromagnetic wave is easy to cause electromagnetic pollution and interference to an external circuit or signal while forming electromagnetic noise.

It should be understood that when the bare die packaging-based chip packaging assembly is used in an electronic device, the electromagnetic noise externally radiated by the chip packaging assembly has a risk of interfering with a radio frequency circuit; or an electromagnetic wave externally radiated by a radio frequency circuit also has a risk of interfering with the chip packaging assembly. The crosstalk causes specific impact on performance of the electronic device. For example, in a frequency range of 5 GHz to 6 GHz, electromagnetic noise externally radiated by the chip packaging assembly is easy to cause crosstalk to the radio frequency circuit, and affects normal operation of the radio frequency circuit; or an electromagnetic wave externally radiated by the radio frequency circuit and a corresponding antenna is easy to cause crosstalk to the chip packaging assembly, and affects normal operation of the chip packaging assembly.

The bare die packaging-based chip packaging assembly has problems such as high electromagnetic noise and radio frequency interference. Embodiments of this application provide a heat dissipation assembly, a chip packaging assembly, and an electronic device in which the chip packaging assembly is used. The heat dissipation assembly in each embodiment is integrated into the chip packaging assembly to serve as a part of the chip packaging assembly, but is not limited thereto. In some other implementations, the heat dissipation assembly may alternatively be an independent assembly. During assembly, the heat dissipation assembly is assembled with structures such as a substrate and a chip to form the chip packaging assembly.

In some embodiments, the electronic device may be, for example, a router or a switch. It should be understood that the electronic device may further include structures such as a radio frequency circuit and a filter. This is not limited.

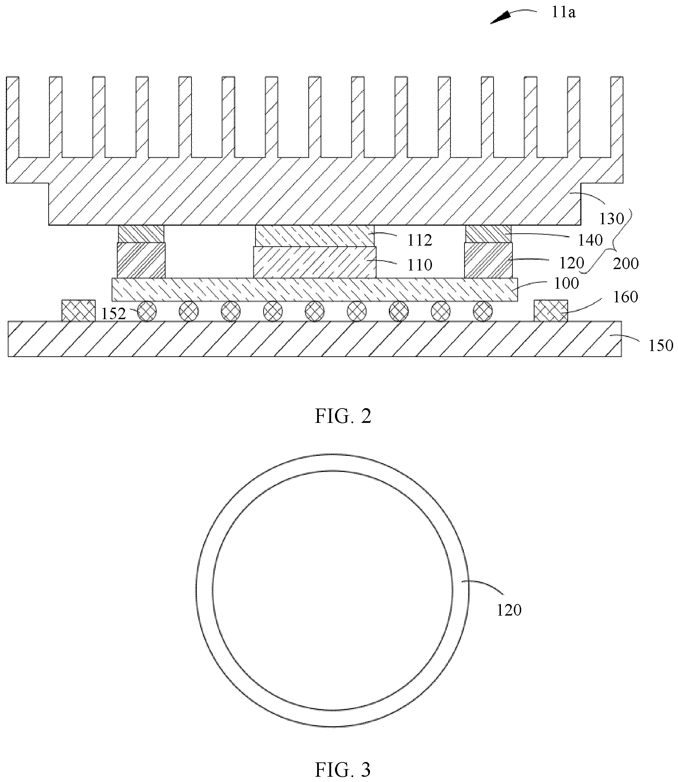

With reference to FIG. 2, an embodiment of this application provides a chip packaging assembly 11a. The chip packaging assembly 11a includes a substrate 100, a chip 110, and a heat dissipation assembly 200. The heat dissipation assembly 200 includes a seal ring 120, a suppression ring 140, and a heat sink 130.

In some embodiments, as shown in FIG. 3, the seal ring 120 may be an enclosed ring-shaped structure. For example, a cross-sectional shape of the seal ring 120 may be a rectangle or a circle. It should be understood that the cross-sectional shape of the seal ring 120 is not limited in this application. The cross-sectional shape of the seal ring 120 may be adaptively designed based on an actual structure requirement of the chip packaging assembly (11a or 11b). This is not limited. In some other embodiments, the cross-sectional shape of the seal ring 120 may alternatively be a trapezoid, a D-shape, or the like.

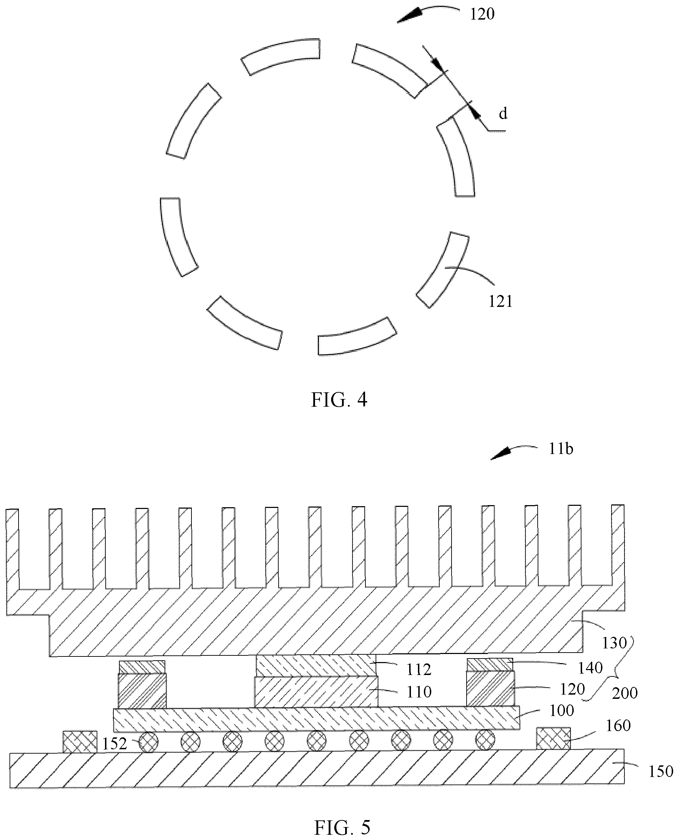

In some embodiments, as shown in FIG. 4, the seal ring 120 may include a plurality of substructures 121. The plurality of substructures 121 are spaced apart on a periphery of the chip 121. A distance d between every two adjacent substructures 121 is a quarter of a wavelength corresponding to a frequency of an electromagnetic wave to be suppressed. In this way, electromagnetic radiation of the corresponding frequency can be suppressed.

In some embodiments, the suppression ring 140 surrounds the chip 110 and may shield an electromagnetic wave radiated by the chip 110. This reduces electromagnetic noise of the chip packaging assembly 11a, to reduce electromagnetic pollution. In some other embodiments, the suppression ring 140 may absorb an electromagnetic wave radiated by the chip 110. This can also reduce electromagnetic noise, to reduce electromagnetic pollution. It should be understood that the suppression ring 140 provided in embodiments of this application may be flexible (for example, a conductive gasket mentioned below) or rigid (for example, a ring-shaped mechanical part made of a wave-absorbing material mentioned below). The suppression ring 140 can suppress electromagnetic wave radiation. Suppressing electromagnetic wave radiation may be, for example, shielding an electromagnetic wave or absorbing an electromagnetic wave. In some embodiments, a material of the suppression ring may be, for example, as described below.

In some embodiments, the suppression ring 140 is located on a side that is of the seal ring 120 and that is away from the substrate 100. That is, the suppression ring 140 is connected between the seal ring 120 and the heat sink 130, to reduce or even eliminate an original gap between the seal ring 120 and the heat sink 130. It should be understood that the substrate 100 and the heat dissipation assembly 200 jointly form an enclosed space. The chip 110 is disposed in the enclosed space. A material of the heat sink 130 may be, for example, a metal or a nonmetallic heat conducting material. The electromagnetic wave radiated by the chip 110 in the enclosed space to outside of the chip packaging assembly 11a can be suppressed through cooperation between the suppression ring 140, the heat sink 130, and the seal ring 120, to reduce the electromagnetic noise of the chip packaging assembly 11a and a possibility of crosstalk between the chip packaging assembly 11a and a radio frequency circuit.

It should be understood that the chip packaging assembly in each embodiment is merely described by using the radio frequency circuit as an example, but it is not limited to that the chip packaging assembly is only for the radio frequency circuit. The chip packaging assembly in each embodiment may alternatively reduce a possibility of crosstalk with another chip packaging assembly. This is not limited.

In some embodiments, the suppression ring 140 may be fastened through adhesive backing; or the suppression ring 140 may be fastened through adhesive dispensing. This is not limited. For example, the suppression ring 140 is fastened to the seal ring 120 through adhesive backing. Subsequently, the heat sink 130 is fastened through a screw or the like. The suppression ring 140 is located between the seal ring 120 and the heat sink 130.

If the suppression ring is flexible, the suppression ring may be sandwiched between the seal ring and the heat sink through elastic deformation, to seal the gap between the seal ring and the heat sink. If the suppression ring is rigid, an installation height of the heat sink may be controlled, so that there is a relatively small gap or no gap between the seal ring, the suppression ring, and the heat sink, to ensure an electromagnetic wave suppression effect.

It should be understood that in the chip packaging assembly 11a provided in each embodiment of this application, the suppression ring 140 is disposed between the seal ring 120 and the heat sink 130, so that a part, of the electromagnetic wave radiated by the chip 110, in a high frequency range (for example, 20 GHz to 35 GHz) is also difficult to be radiated to the outside. Therefore, the chip packaging assembly 11a in each embodiment may have a better electromagnetic noise suppression effect. The electromagnetic noise of the chip packaging assembly 11a can be reduced while a heat dissipation benefit of the chip 110 is ensured, to ensure normal operation of the chip packaging assembly 11a.

In some embodiments, the heat sink may further have a boss (not shown in the figure). The boss protrudes toward the chip and the substrate. The heat sink having the boss may be more easily in contact with the chip, to conduct heat dissipated by the chip.

It should be understood that, through the cooperation between the suppression ring 140, the heat sink 130, and the seal ring 120, it is difficult for the electromagnetic wave radiated by the chip 110 to penetrate to the outside and for an external electromagnetic wave to penetrate into the enclosed space. This can reduce radiated power of the electromagnetic wave externally radiated by the chip packaging assembly 11a, to reduce a possibility that the chip 110 affects the radio frequency circuit. This can also reduce a possibility that an electromagnetic wave radiated by the radio frequency circuit affects the chip 110.

In some embodiments, the suppression ring 140 is a conductive gasket. The conductive gasket has specific elasticity and can be compressed to some extent. Based on this, a compression rate of the conductive gasket is controlled, so that the conductive gasket can maintain good bonding with the seal ring 120 and the heat sink 130 through elastic deformation, to maximally eliminate the gap between the heat sink 130 and the seal ring 120. This reduces a possibility that the electromagnetic wave radiated by the chip 110 penetrates to the outside.

In some embodiments, the conductive gasket may be connected between the seal ring 120 and the heat sink 130 without a gap, to eliminate the original gap between the seal ring 120 and the heat sink 130. In addition, an enclosed space is formed among the substrate 100, the seal ring 120, the conductive gasket, and the heat sink 130. In this way, it is more difficult for the electromagnetic wave radiated by the chip 110 to penetrate to the outside, so that the chip packaging assembly 11a has a better electromagnetic noise suppression effect.

For example, the conductive gasket is sandwiched between the seal ring 120 and the heat sink 130, and is away from the substrate 100. The compression rate of the conductive gasket is controlled to be 40% by controlling a distance between the heat sink 130 and the substrate 100. The conductive gasket is stably fastened between the seal ring 120 and the heat sink 130 through elastic deformation. In this way, the conductive gasket has specific resilience, and the gap between the seal ring 120 and the heat sink 130 can be maximally eliminated.

In some embodiments, on a basis that the conductive gasket has specific elasticity, the conductive gasket may further serve as a cushion to protect the chip 110 during installation of the heat sink 130, to reduce pressure borne by the chip 110. It should be understood that when the heat sink 130 is fastened through the screw or the like, the heat sink 130 gradually presses the conductive gasket and makes the conductive gasket be compressed as the distance between the heat sink 130 and the substrate 100 decreases. Because the conductive gasket has resilience to return to an initial state, the resilience may reduce a force applied by the heat sink 130 on the chip 110, so that the pressure borne by the chip can be reduced.

In some embodiments, the conductive gasket includes an elastic inner core and a conductive outer layer. The conductive outer layer is wrapped around the elastic inner core. Through the elastic inner core, the conductive gasket has specific elasticity, to implement good bonding. Through the conductive outer layer, the conductive gasket may be electrically connected to structures such as the heat sink 130 and the seal ring 120, to ensure an effect of shielding the electromagnetic wave radiated by the chip 110.

In some embodiments, the elastic inner core is made of a foam material. The foam material may be, for example, a material having specific elasticity, such as polyurethane.

In some embodiments, the conductive outer layer is made of conductive fiber cloth. The conductive fiber cloth may be, for example, a material having high electrical conductivity, such as nickel/copper (Ni/Cu).

In some embodiments, the conductive gasket may alternatively be a conductive sponge. The conductive sponge also has electrical conductivity and compressibility, and can implement good bonding with the seal ring 120 and the heat sink 130 and shield electromagnetic waves. It should be understood that a compression rate of the conductive sponge is higher than that of the conductive gasket including the elastic inner core and the conductive outer layer. For example, the compression rate of the conductive gasket is 30% to 50%, and the compression rate of the conductive sponge is 40% to 60%. When the conductive sponge is used as the suppression ring 140, the conductive sponge may have a larger size to ensure good bonding between the seal ring 120, the conductive sponge, and the heat sink 130.

In some other embodiments, the suppression ring 140 is a ring-shaped mechanical part made of a wave-absorbing material, and is located between the seal ring 120 and the heat sink 130, to absorb and attenuate the electromagnetic wave radiated by the chip 110. It should be understood that, different from the conductive gasket, the ring-shaped mechanical part may be disposed on a side that is of the seal ring 120 and that faces the heat sink 130; or the ring-shaped mechanical part may be disposed on a side that is of the heat sink 130 and that faces the seal ring 120.

An example in which the ring-shaped mechanical part is located on the side that is of the seal ring 120 and that faces the heat sink 130 is used for description. With reference to FIG. 5, an embodiment of this application provides a chip packaging assembly 11b. In comparison with the chip packaging assembly 11a, in the chip packaging assembly 11b, a suppression ring 140 of a heat dissipation assembly 200 is a ring-shaped mechanical part made of a wave-absorbing material. The ring-shaped mechanical part may not be in contact with a heat sink 130. That is, there may be a specific gap between the ring-shaped mechanical part and the heat sink 130. Unlike a conductive gasket, there is no need to maintain connection relationships with a seal ring 120 and the heat sink 130. Corresponding to position relationships of the ring-shaped mechanical part with the seal ring 120 and the heat sink 130, a formed enclosed space may have a specific gap, and does not need to be completely enclosed.

It should be understood that when the ring-shaped mechanical part is used in the chip packaging assembly (11a or 11b) in each embodiment, based on an absorption and attenuation effect of the ring-shaped mechanical part on electromagnetic waves, the electromagnetic wave radiated by the chip 110 is absorbed and attenuated by the ring-shaped mechanical part when passing through the gap. The ring-shaped mechanical part may convert electromagnetic energy into thermal energy or energy in another form by absorbing and attenuating the electromagnetic wave radiated by the chip 110, to consume the electromagnetic energy. This reduces radiated power of the electromagnetic wave externally radiated by the chip 110, to reduce electromagnetic noise.

In some other embodiments, when the ring-shaped mechanical part is located on the side that is of the heat sink 130 and that faces the seal ring 120, there may also be a specific gap between the ring-shaped mechanical part and the seal ring 120. This is not limited.

In some embodiments, the wave-absorbing material may be, for example, graphite, graphene, carbon fiber, magnetic ceramic, or a conductive polymer.

It should be understood that although the chip packaging assembly in each embodiment is mainly described with the conductive gasket as the suppression ring, the suppression ring in each embodiment may alternatively be the ring-shaped mechanical part to achieve a similar effect of reducing electromagnetic noise. In addition, when the suppression ring is the ring-shaped mechanical part, the ring-shaped mechanical part does not need to completely seal a gap between the seal ring and the heat sink. That is, after the heat sink is installed, there may be a specific gap between the heat sink, the ring-shaped mechanical part, and the seal ring. However, through absorption and attenuation of electromagnetic waves by the ring-shaped mechanical part, it is difficult for the electromagnetic wave radiated by the chip to penetrate through the gap to the outside. This can also reduce the electromagnetic noise of the chip packaging assembly, to ensure normal operation of the chip packaging assembly.

In some implementations, a shape of the suppression ring 140 may be, for example, a circular ring, a hexagonal ring, or a square ring. It should be understood that a width, a thickness, and the like of the suppression ring 140 are not limited in this application. The shape of the suppression ring 140 may be adaptively designed based on an actual structure requirement of the chip packaging assembly (11a or 11b). This is not limited. In some other embodiments, the shape of the suppression ring 140 may alternatively be an elliptical ring or the like.

In some implementations, in a radial direction of the suppression ring 140, a cross-sectional shape of the suppression ring 140 may be, for example, a rectangle, a semicircle, or a circle. It should be understood that the cross-sectional shape of the suppression ring 140 is not limited in this application. The cross-sectional shape of the suppression ring 140 may be adaptively designed based on the actual structure requirement of the chip packaging assembly (11a or 11b). This is not limited. In some other embodiments, the cross-sectional shape of the suppression ring 140 may alternatively be a trapezoid, a D-shape, a circular segment, or the like. The circular segment is a remaining part of a circle after a part of the circle is cut off through a straight line. A semicircle is a special circular segment.

In some embodiments, the chip packaging assembly (11a or 11b) further includes a circuit board 150. The circuit board 150 is located on a side that is of the substrate 100 and that is away from the chip 110. In other words, the chip 110 and the circuit board 150 are respectively located on two opposite sides of the substrate 100. The circuit board 150 may be electrically connected to the chip 110 through a conductive ball 152, to cooperate with the chip 110 to implement functions such as communication and data processing. The conductive ball 152 may be, for example, a conductive solder ball.

In some embodiments, the chip packaging assembly (11a or 11b) further includes an electronic element 160. The electronic element 160 is disposed on the circuit board 150 and around the substrate 100. The electronic element 160 may be, for example, a capacitor, an inductor, or a resistor.

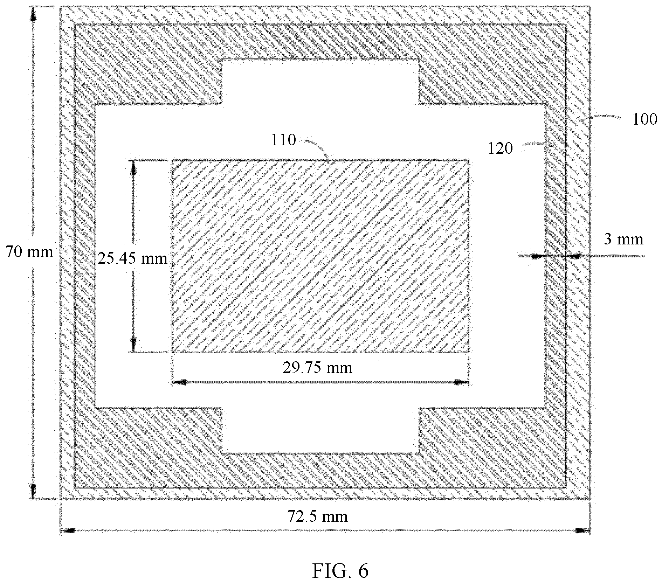

With reference to FIG. 2 and FIG. 6, the following describes the chip packaging assembly 11a in each embodiment by using a specific example. Related parameters of the chip packaging assembly are as follows:

Power consumption of the chip 110: 372 W (Max) for a SoC (System on Chip, system on chip) and 17.7 W (Max) for an HBM (High Bandwidth Memory, high bandwidth memory).

TIM 112: a carbon fiber thermal pad or a PCM (Phase Change Material, phase change material). A percentage of a covered area of the chip 110 is greater than or equal to 90%. A thermal resistance is less than or equal to 0.2 Kcm²/W.

SerDes (Serializer/DESerializer, serializer/deserializer): A maximum rate in PAM4 (Pulse Amplitude Modulation, pulse amplitude modulation) is 58 Gbps.

Packaging: bare die packaging. A size of the chip 110 is 29.75 mm x 25.45 mm. A size of the substrate 100 is 70 mm x 72.5 mm. A shape of the seal ring 120 is basically the same as that of the substrate 100. A narrowest side width of the seal ring 120 is 3 mm.

Suppression ring 140: The suppression ring 140 is a conductive gasket. The elastic inner core is made of a polyurethane foam material. The conductive outer layer is made of nickel/copper conductive fiber cloth. A surface resistance is less than or equal to 0.1 ohm. A size is 72 mm x 74.5 mm x 4 mm. An initial thickness is 2 mm. A compression rate is 30% to 50%.

A minimum distance between the heat sink 130 and the seal ring 120 is 1.2 mm. The suppression ring 140 is sandwiched between the heat sink 130 and the seal ring 120 through elastic deformation. The compression rate of the suppression ring 140 is substantially 40%. This may be verified by a ratio of the initial thickness (for example, 2 mm) of the suppression ring 140 to the minimum distance (for example, 1.2 mm) between the heat sink 130 and the seal ring 120.

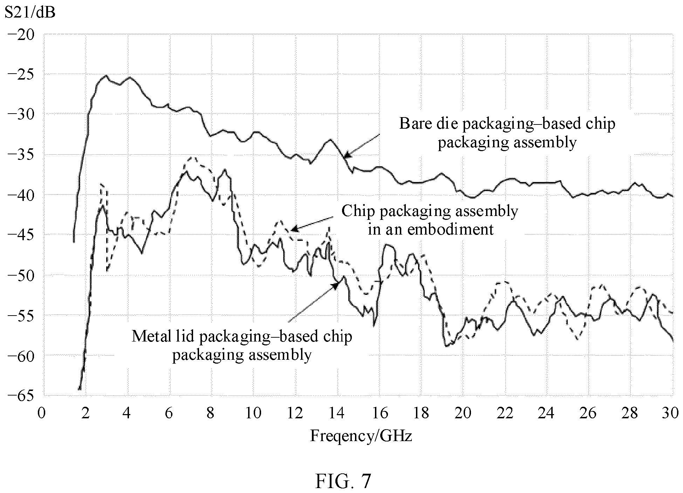

FIG. 7 is a diagram of simulation test data of an electromagnetic noise shielding effect of a chip packaging assembly. With reference to FIG. 7, given same excitation power, radiated power (or electromagnetic noise) of the chip packaging assembly in each embodiment of this application is basically the same as that of a metal lid packaging-based chip packaging assembly. In a frequency range of 2 GHz to 30 GHz, the externally radiated power of the chip packaging assembly in each embodiment may be kept relatively low.

Compared with a bare die packaging-based chip packaging assembly, the chip packaging assembly in each embodiment can ensure that the electromagnetic noise of the chip packaging assembly is relatively low while ensuring a heat dissipation benefit through bare die packaging.

It should be understood that the chip packaging assembly in each embodiment of this application still maintains a relatively good electromagnetic noise suppression effect in a high frequency range above 20 GHz, and radiated power of an electromagnetic wave in the high frequency range is still kept relatively low.

Based on this, when the chip packaging assembly in each embodiment of this application is used in an electronic device, radiated power of the electromagnetic noise of the chip packaging assembly in a wide frequency range can be kept relatively low, to reduce a possibility of mutual crosstalk with a radio frequency circuit.

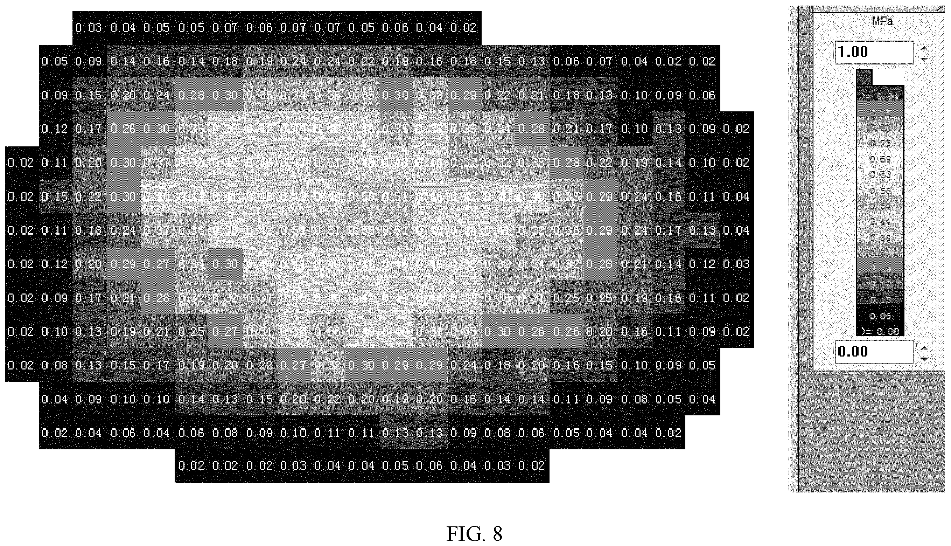

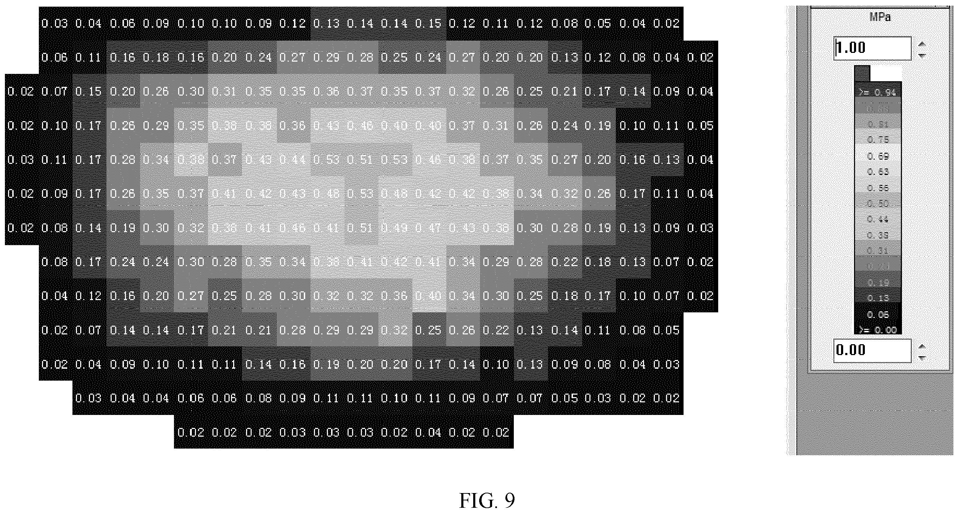

FIG. 8 is a diagram of pressure test data of a chip in an existing chip packaging assembly. FIG. 9 is a diagram of pressure test data of a chip in a chip packaging assembly according to an embodiment of this application. With reference to FIG. 8 and FIG. 9, a chip protected by a conductive gasket that serves as a cushion bears less pressure on the whole than a chip not protected by a conductive gasket. It should be understood that based on the protection of the conductive gasket, the chip packaging assembly may have better pressure bearing performance, to ensure structural stability of the chip packaging assembly during assembly, transportation, and the like.

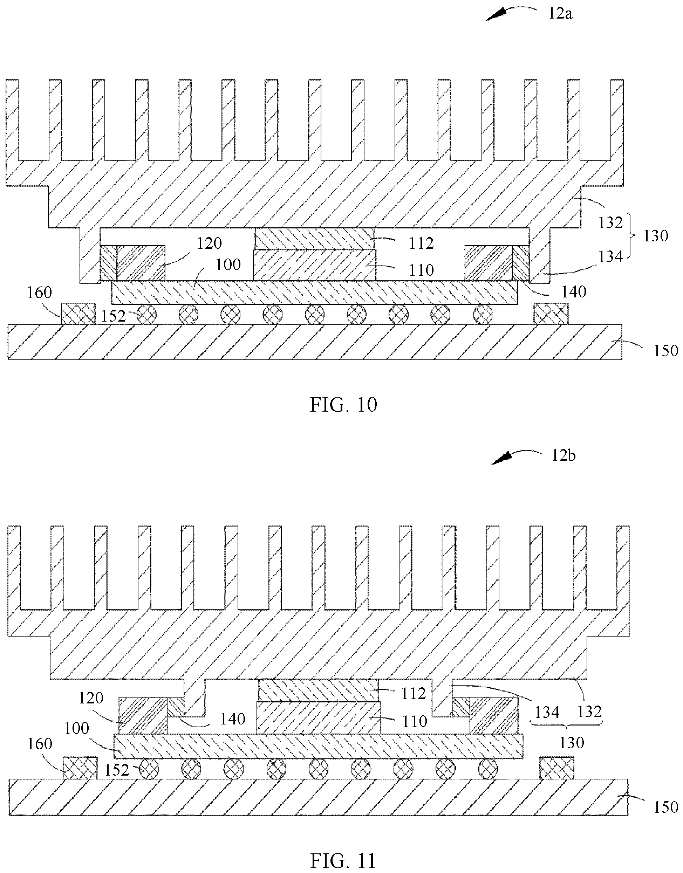

With reference to FIG. 10, an embodiment of this application provides another chip packaging assembly 12a, including a substrate 100, a chip 110, a seal ring 120, a heat sink 130, and a suppression ring 140. However, different from the chip packaging assemblies (11a and 11b) in the foregoing embodiments, the heat sink 130 in this embodiment includes a heat sink body 132 and a ring-shaped support 134. The ring-shaped support 134 is located on a side of the heat sink body 132 and extends toward the substrate 100. The ring-shaped support 134 of the heat sink 130 extends to be spaced from the seal ring 120. The suppression ring 140 is disposed between the ring-shaped support 134 and the seal ring 120.

It should be understood that the suppression ring 140 may also reduce or even eliminate a gap between the heat sink 130 and the seal ring 120 by disposing the suppression ring 140 between the ring-shaped support 134 and the seal ring 120. This can suppress an electromagnetic wave radiated by the chip 110, to reduce electromagnetic noise of the chip packaging assembly 12a. In addition, the chip packaging assembly 12a and a radio frequency circuit are not easy to interfere with each other, to ensure normal operation of the chip packaging assembly 12a and the radio frequency circuit.

In some other embodiments, the suppression ring may alternatively be located between the heat sink body and the seal ring. This can also shield the electromagnetic wave radiated by the chip, to reduce the electromagnetic noise of the chip packaging assembly.

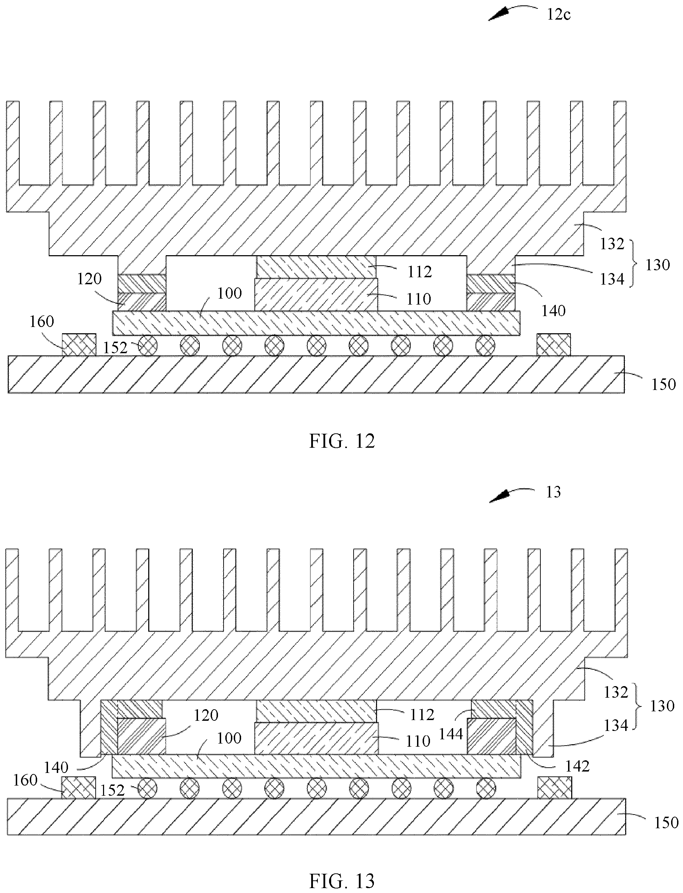

With reference to FIG. 10, in some embodiments, the ring-shaped support 134 is located on an outer side of the seal ring 120, but is not limited thereto. With reference to FIG. 11, an embodiment of this application provides another chip packaging assembly 12b. In comparison with the chip packaging assembly 12a, a ring-shaped support 134 of the chip packaging assembly 12b is located on an inner side of a seal ring 120. With reference to FIG. 12, an embodiment of this application provides another chip packaging assembly 12c. In comparison with the chip packaging assembly 12a, a ring-shaped support 134 of the chip packaging assembly 12c is located on a side that is of a seal ring 120 and that is away from a substrate 100.

It should be understood that structures of the chip packaging assemblies (12b and 12c) are similar to a structure of the chip packaging assembly 12a, and both can implement functions similar to those of the chip packaging assembly 12a, to suppress an electromagnetic wave radiated by a chip 110 and reduce electromagnetic noise of the chip packaging assemblies (12b and 12c). Details are not described herein again.

With reference to FIG. 13, an embodiment of this application provides still another chip packaging assembly 13. In comparison with the chip packaging assembly (12a, 12b, and 12c) in the foregoing embodiments, a suppression ring 140 in this embodiment includes a first ring-shaped part 142 and a second ring-shaped part 144. Both the first ring-shaped part 142 and the second ring-shaped part 144 are ring-shaped. The first ring-shaped part 142 extends in an axial direction of the suppression ring 140. The second ring-shaped part 144 extends in a radial direction of the suppression ring 140. In this way, in the radial direction of the suppression ring 140, a cross section of the suppression ring 140 is substantially L-shaped. The first ring-shaped part 142 is disposed between a ring-shaped support 134 and a seal ring 120, and the second ring-shaped part 144 is disposed between a heat sink body 132 and the seal ring 120, to cooperate with each other to suppress an electromagnetic wave radiated by a chip 110. This can reduce electromagnetic noise of the chip packaging assembly and a possibility of crosstalk with a radio frequency circuit.

In some embodiments, the first ring-shaped part 142 may be, for example, a ring-shaped mechanical part made of a wave-absorbing material; or the first ring-shaped part 142 may be, for example, a conductive gasket. The second ring-shaped part 144 may be, for example, a conductive gasket. In this way, the second ring-shaped part 144 can further reduce pressure borne by the chip 110 while shielding the electromagnetic wave.

In some other embodiments, the first ring-shaped part 142 and the second ring-shaped part 144 may be an integrated ring-shaped mechanical part made of a wave-absorbing material; or the first ring-shaped part 142 and the second ring-shaped part 144 may be an integrated conductive gasket.

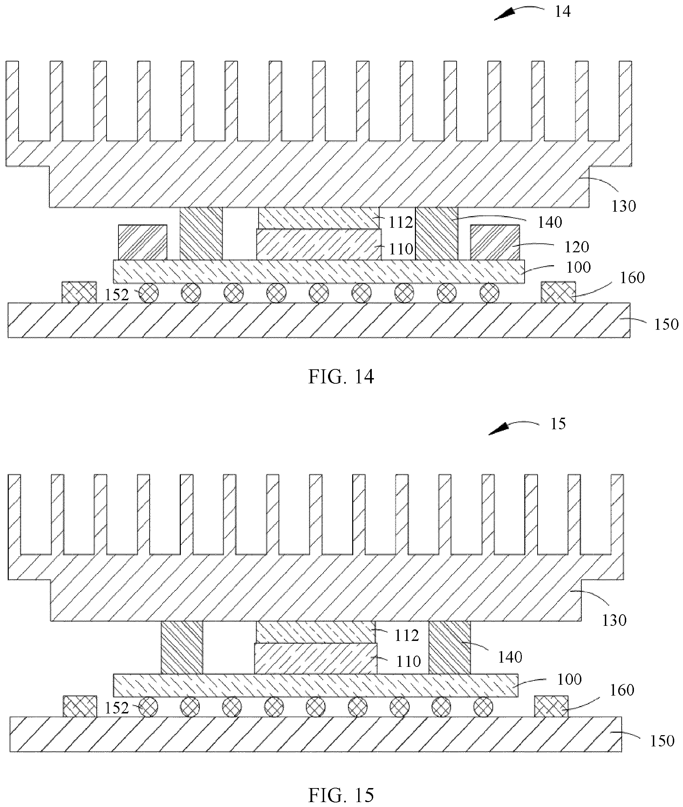

With reference to FIG. 14, an embodiment of this application provides yet another chip packaging assembly 14, including a substrate 100, a chip 110, a seal ring 120, a heat sink 130, and a suppression ring 140. Different from the chip packaging assemblies (11a, 11b, 12a, 12b, 12c, and 13) in the foregoing embodiments, the suppression ring 140 in this embodiment is directly disposed between the substrate 100 and the heat sink 130 through surrounding, and is located on an inner side of the seal ring 120. The substrate 100, the suppression ring 140, and the heat sink 130 jointly form an enclosed space. The chip 110 is located in the enclosed space.

In this way, an electromagnetic wave radiated by the chip 110 is directly suppressed by the suppression ring 140 and the heat sink 130. Similar to the chip packaging assemblies (11a, 11b, 12a, 12b, 12c, and 13) in the foregoing embodiments, it is difficult for the electromagnetic wave radiated by the chip 110 to penetrate to outside of the chip packaging assembly 14. This can also reduce a possibility that the chip 110 externally radiates an electromagnetic wave, to reduce electromagnetic noise of the chip packaging assembly 14. In addition, the chip packaging assembly 14 and the radio frequency circuit are not easy to cross talk with each other.

In some embodiments, when the suppression ring 140 is a conductive gasket, because the conductive gasket is directly located between the substrate 100 and the heat sink 130, a size of the conductive gasket in this embodiment is larger than those of related structures (for example, the conductive gasket located between the seal ring 120 and the heat sink 130) in the foregoing embodiments. Correspondingly, an elastic deformation range of the conductive gasket is relatively large. A skilled person can more conveniently control resilience of the conductive gasket, to improve compatibility of the conductive gasket and better protect the chip 110.

For example, a compression rate of the conductive gasket is controlled to be 30% to 40%. If a thickness of the conductive gasket between the seal ring 120 and the heat sink 130 is 2 mm, the elastic deformation range of the conductive gasket is 0.6 mm to 0.8 mm. If a thickness of the conductive gasket between the substrate 100 and the heat sink 130 is 6 mm, an elastic deformation range of the conductive gasket is 1.8 mm to 2.4 mm. Therefore, the conductive gasket with the thickness of 6 mm can have a larger adjustment range than the conductive gasket with the thickness of 2 mm. During subsequent installation of the heat sink 130, the skilled person can relatively conveniently adjust a distance between the heat sink 130 and the substrate 100, to adjust the compression rate of the conductive gasket and package the chip packaging assembly 14.

With reference to FIG. 15, an embodiment of this application provides still yet another chip packaging assembly 15, including a substrate 100, a chip 110, a heat sink 130, and a suppression ring 140. Different from the chip packaging assembly 14 in the foregoing embodiment, the chip packaging assembly 15 is not provided with the seal ring 120. The suppression ring 140 is disposed between the substrate 100 and the heat sink 130 through surrounding, to form an enclosed space together with the substrate 100 and the heat sink 130. It should be understood that in this embodiment, an electromagnetic wave radiated by the chip 110 may also be suppressed through cooperation between the substrate 100, the heat sink 130, and the suppression ring 140, to reduce electromagnetic noise of the chip packaging assembly 15. In addition, the chip packaging assembly 15 and a radio frequency circuit are not easy to cross talk with each other.

The foregoing descriptions are merely specific implementations of this application. It should be noted that a person of ordinary skill in the art may make several improvements or polishing without departing from the principle of this application and the improvements or polishing shall fall within the protection scope of this application.

## Claims

1. A heat dissipation assembly for reducing electromagnetic noise of a chip, wherein the heat dissipation assembly comprises a heat sink, a seal ring, and a suppression ring;
the suppression ring is connected between the seal ring and the heat sink, and is configured to surround a chip; and
the heat dissipation assembly is configured to form an enclosed space together with a substrate carrying the chip, so that the chip is located in the enclosed space; and the suppression ring is configured to shield an electromagnetic wave radiated by the chip.

2. The heat dissipation assembly according to claim 1, wherein the suppression ring is located on a side that is of the seal ring and that faces the heat sink.

3. The heat dissipation assembly according to claim 1, wherein the heat sink comprises a heat sink body and a ring-shaped support, the ring-shaped support is located on a side of the heat sink body and spaced from the seal ring, and the suppression ring is partially or completely sandwiched between the ring-shaped support and the seal ring.

4. The heat dissipation assembly according to claim 3, wherein the suppression ring comprises a first ring-shaped part and a second ring-shaped part, the first ring-shaped part is sandwiched between the ring-shaped support and the seal ring, and the second ring-shaped part is sandwiched between the heat sink body and the seal ring.

5. The heat dissipation assembly according to any one of claims 1 to 4, wherein the suppression ring is connected to the seal ring and the heat sink without a gap.

6. The heat dissipation assembly according to any one of claims 1 to 5, wherein the suppression ring is a flexible conductive gasket, and the conductive gasket is sandwiched between the seal ring and the heat sink through elastic deformation.

7. The heat dissipation assembly according to claim 6, wherein the conductive gasket comprises an elastic inner core and a conductive outer layer, and the conductive outer layer is wrapped around the elastic inner core.

8. The heat dissipation assembly according to claim 7, wherein the elastic inner core is made of a foam material, and the conductive outer layer is made of conductive fiber cloth.

9. The heat dissipation assembly according to claim 6, wherein the conductive gasket is conductive foam.

10. The heat dissipation assembly according to any one of claims 1 to 9, wherein the seal ring is an enclosed ring-shaped structure; or
the seal ring comprises a plurality of substructures, and the plurality of substructures are spaced apart on a periphery of the chip.

11. A heat dissipation assembly for reducing electromagnetic noise of a chip, wherein the heat dissipation assembly comprises a heat sink, a seal ring, and a suppression ring;
the suppression ring is located between the seal ring and the heat sink, and is configured to surround a chip; and
the heat dissipation assembly is configured to form an enclosed space together with a substrate carrying the chip, so that the chip is located in the enclosed space; and the suppression ring is configured to absorb an electromagnetic wave radiated by the chip.

12. The heat dissipation assembly according to claim 11, wherein the suppression ring is located on a side that is of the seal ring and that faces the heat sink.

13. The heat dissipation assembly according to claim 11, wherein the heat sink comprises a heat sink body and a ring-shaped support, the ring-shaped support is located on a side of the heat sink body and spaced from the seal ring, and the suppression ring is partially or completely located between the ring-shaped support and the seal ring.

14. The heat dissipation assembly according to claim 13, wherein the suppression ring comprises a first ring-shaped part and a second ring-shaped part, the first ring-shaped part is located between the ring-shaped support and the seal ring, and the second ring-shaped part is located between the heat sink body and the seal ring.

15. The heat dissipation assembly according to any one of claims 11 to 14, wherein the suppression ring is a ring-shaped mechanical part made of a wave-absorbing material.

16. The heat dissipation assembly according to any one of claims 11 to 15, wherein the seal ring is an enclosed ring-shaped structure; or
the seal ring comprises a plurality of substructures, and the plurality of substructures are spaced apart on a periphery of the chip.

17. A heat dissipation assembly for reducing electromagnetic noise of a chip, wherein the heat dissipation assembly comprises a heat sink and a suppression ring;
the suppression ring is located on a side of the heat sink, and is configured to surround a chip; and
the heat dissipation assembly is configured to form an enclosed space together with a substrate carrying the chip, so that the chip is located in the enclosed space; and the suppression ring is a conductive gasket, or the suppression ring is a ring-shaped mechanical part made of a wave-absorbing material.

18. A chip packaging assembly, wherein the chip packaging assembly comprises a chip, a substrate, and the heat dissipation assembly for reducing electromagnetic noise of a chip according to any one of claims 1 to 17; and
the chip is disposed on the substrate, the substrate and the heat dissipation assembly jointly form an enclosed space, and the chip is located in the enclosed space.

19. An electronic device, comprising the chip packaging assembly according to claim 18.
